Europäisches Patentamt

European Patent Office

Office européen des brevets

(11) Veröffentlichungsnummer: **0 285 900**
**A2**

## (12) EUROPÄISCHE PATENTANMELDUNG

(21) Anmeldenummer: 88104544.7

(51) Int. Cl.⁴: **H05K 3/04**

(22) Anmeldetag: 22.03.88

(30) Priorität: 04.04.87 DE 3711403

(43) Veröffentlichungstag der Anmeldung:
12.10.88 Patentblatt 88/41

(84) Benannte Vertragsstaaten:
DE FR GB IT

(71) Anmelder: BAYER AG
Konzernverwaltung RP Patentabteilung
D-5090 Leverkusen 1 Bayerwerk(DE)

(72) Erfinder: Dziurla, Heinz-Jürgen, Dipl. Ing.
Solingerstrasse 35
D-5090 Leverkusen 1(DE)
Erfinder: Weber, Hans-Leo, Dipl. Ing.
Dahlienweg 7
D-4049 Rommerskirchen(DE)
Erfinder: Freitag, Dieter, Dr.
Hasenheide 10
D-4150 Krefeld Traar(DE)
Erfinder: Waldenrath, Werner, Dipl. Ing.
Maastrichter Strasse 40
D-5000 Koeln 1(DE)

(54) Verfahren zur Herstellung gedruckter Schaltungen.

(57) Die vorliegende Erfindung betrifft ein Verfahren zur Herstellung gedruckter Schaltungen durch Aufbringen von Kupfer auf ein Substrat, wobei das die Leiterbahnen bildende Kupfer durch Heißprägen auf das Substrat übertragen wird und die zum Heißprägen erforderliche Wärme in der Trägerfolie des Kupfers erzeugt wird.

EP 0 285 900 A2

## Verfahren zur Herstellung gedruckter Schaltungen

Die vorliegende Erfindung betrifft ein Verfahren zur Herstellung gedruckter Schaltungen durch Heißprägen, bei dem die Wärme in einer Trägerfolie erzeugt wird.

Der Einsatz gedruckter Schaltungen ist in der Elektro-und Elektronikindustrie weit verbreitet. Es kommen starre und flexible Materialien sowie Kombinationen aus beiden zum Einsatz. Es wird zwischen lötbadfesten und nicht lötbadgeeigneten Systemen unterschieden.

Als Basismaterialien werden z.B. glasfaserverstärkte Epoxidharzplatten, Polyimid-oder Polyesterfolien verwendet. Die Erzeugung des Leiterbahnbildes auf dem zunächst vollflächig mit Kupfer beschichteten Substrat erfolgt in einem Ätzprozeß, nachdem das mit einem fotoempfindlichen Lack beschichtete Substrat mit dem zu erzeugenden Leiterbahnbild belichtet wurde. Die Kupfererbeschichtung besteht aus Elektrolytkupfer in einer Stärke von z.B. 0,035 mm, das mit einem hochwärme-und chemi kalienbeständigen Kleber auf das Substrat aufgebracht wird. Zur Herstellung einer gedruckten Schaltung ist also neben der Vorbereitung der fotografischen Vorlage ein langwieriger, mehrstufiger Ätzprozeß erforderlich, der an jedem Einzelstück wiederholt werden muß und sehr genau in bezug auf Temperaturen und Konzentrationen der Agenzien kontrolliert werden muß. Trotzdem ist die Gefahr von Ätzfehlern gegeben, wie z.B. Unterätzung o.ä.

Es hat deshalb nicht an Versuchen gefehlt, das Ätzverfahren zu umgehen. So wurde z.B. vorgeschlagen, die Leiterbahnen durch Aufdrucken eines mit einem elektrisch leitfähigen Stoff gefüllten Lackes herzustellen. Dieses Verfahren wird z.B. bei der Herstellung der Basisfolien für Membranschalter bevorzugt.

Ein weiteres Verfahren ist das Übertragen der Leiterbahnen durch Heißprägen. Bei diesem Verfahren sind die Leiterbahnen auf einem Prägestempel erhaben dargestellt. Eine Kunststofffolie, z.B. Polyesterfolie, ist mittels eines Haftvermittlers, auch als Trennschicht bezeichnet, mit einer speziellen Kupferfolie beschichtet, dessen Siegeltemperatur oberhalb der Schmelztemperatur der o.g. Trennschicht liegt. Mit diesem Verfahren können Leiterbahnen auf geeignete thermoplastische ober nicht thermoplastische Substrate beliebiger Form aufgebracht werden. Insbesondere ist für große Stückzahlen Endlosdruck mit walzenförmigen Prägewerkzeugen möglich.

Der vorliegenden Erfindung lag die Aufgabe zugrunde, einige Nachteile des o.g.

Prägeverfahrens zu umgehen. Diese Nachteile sind insbesondere:

1. Die Mindestbreite der Leiterbahnen soll 0,2 mm nicht unterschreiten.

2. Der Mindestabstand zwischen benachbarten Leiterbahnen soll nicht weniger als 0,5 mm betragen.

3. Zur Erzeugung hochwertiger Leiterplatten bedarf es einer sehr genauen Temperaturführung des Prägewerkzeuges, wozu es besonders bei größeren Prägewerkzeugen einer aufwendigen Regelung bedarf.

Die vorliegende Erfindung vermeidet die vorerwähnten Nachteile. Überraschend zeigte sich, daß die o.g. Mindestbreiten und -abstände deutlich unterschritten werden können, was die Einsatzmöglichkeiten der erfindungsgemäß hergestellten gedruckten Schaltungen in bezug auf dichter bestückte Schaltungen deutlich erweitert.

Gegenstand der vorliegenden Erfindung ist ein Verfahren zur Herstellung von gedruckten Schaltungen durch Aufbringen von Kupfer auf ein Substrat, welches dadurch gekennzeichnet ist, daß das die Leiterplatten bildende Kupfer durch Heißpräger auf das Substrat übertragen wird und die zum Heißprägen erforderliche Wärme in der Trägerfolie des Kupfers erzeugt wird.

Bei der erfindungsgemäßen Herstellung von gedruckten Schaltungen wird die zum Abschmelzen der Trennschicht und Aktivieren der Heißsiegelschicht erforderliche Wärmeenergie nicht mehr durch ein beheiztes Prägewerkzeug zugeführt, sondern im Trägerband der Kupferfolie direkt erzeugt. Dazu bleibt das Prägewerkzeug in seiner mechanischen Beschaffenheit erhalten, es ist also mit dem erhabenen Bild der Leiterplatten versehen. In einer besonderen Ausführungsform ist das Bild auf Druckplatten übertragen, die ihrerseits an dem Prägestempel befestigt werden.

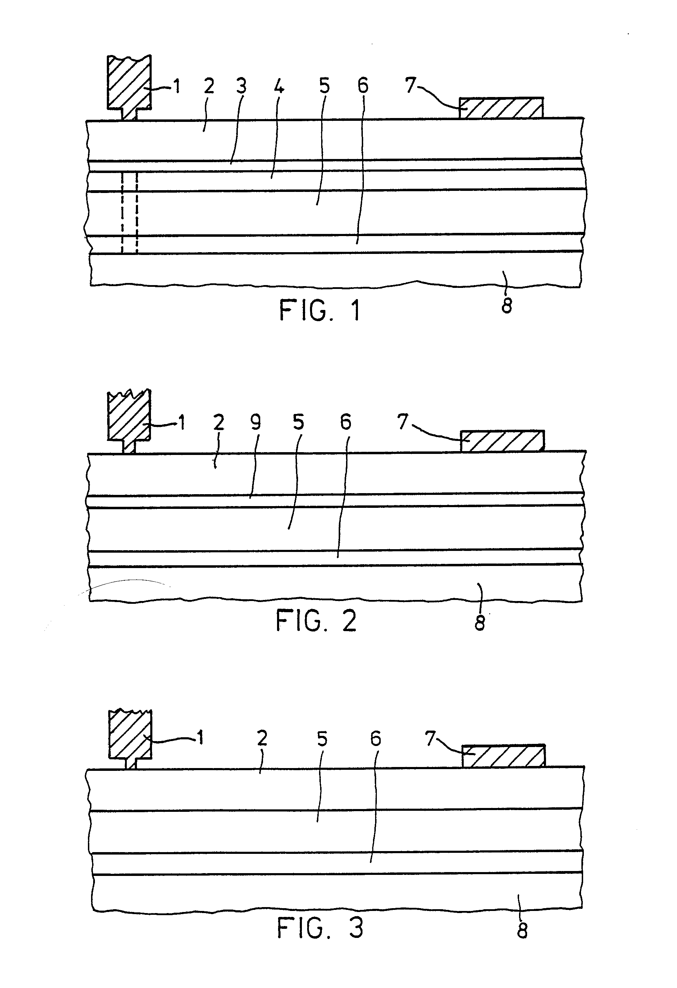

Im Gegensatz zu dem bekannten Verfahren wird das Prägewerkzeug (1) jedoch erfindungsgemäß nicht mehr beheizt, sondern ist als elektrische Elektrode ausgebildet. Die zur Übertragung der Leiterbahnen benötigte Wärme wird in der Trägerfolie (2) der Kupferfolie (5) erzeugt, (s. Fig. 1). Dazu ist die Trägerfolie aus einer mit elektrisch leitfähigem Ruß gefüllten Kunststoffolie hergestellt. Das Prägewerkzeug ist über das Maschinengestell an Masse gelegt, während die Stromzuführung über die mit einer geeigneten Stromquelle verbundene Elektrode (7) erfolgt. Über eine im Hochvakuum auf die Trägerfolie (2) aufgedampfte Aluminiumschicht (3) fließt der Strom praktisch verlustfrei von der Elektrode (7) zum Prägewerkzeug (1). Die Kontaktfläche der Elektrode (7) ist dabei größer zu wählen als die Kontaktfläche des Prägewerkzeuges (1), so daß nur im Bereich des Prägewerkzeuges (1) die Stromdichte so hoch ist, daß in der Trägerfolie (2) genügend hohe Temperaturen entstehen, um die Trennschicht (4) aufzuschmelzen und die Klebschicht (6) zu aktivieren. Dadurch wird die Kupferfolie (5) gemäß dem durch das Prägewerkzeug (1) vorgegebenen Bild auf das Substrat (8) geklebt. Beim Trennen der Trägerfolie (2) vom Substrat (8) bleibt die aufgeklebte Leiterbahn auf dem Substrat haften und ist selber durch die ebenfalls an der Kuperfolie haftende Trennschicht gegen Oxidation und Verschmutzung geschützt.

In einer anderen Ausführungsform der vorliegenden Erfindung (s. Fig. 2) werden die aufgedampfte Aluminiumschicht (3) und die Trennschicht (4) aus Fig. 1 durch einen elektrisch leitenden Kleber (9) ersetzt. Der elektrisch leitende Kleber (9) hat einen spezifischen Durchgangswiderstand, der dem der Trägerfolie (2) ähnlich ist. Die praktisch verlustlose Stromleitung erfolgt in dieser Ausführungsform über die Kupferfolie (5).

In einer weiteren Ausführungsform (s. Fig. 3) wird die Kupferfolie (5) direkt mit der Trägerfolie (2) beschichtet. Diese Beschichtung kann durch Extrudieren oder Begießen geschehen. Diese Ausführungsform macht sich den Umstand zunutze, daß die der direkten Beschichtung von Kupfer mit einem Kunststoff im allgemeinen nur schwache Haftkräfte entstehen.

Die Trägerfolie (2) wird durch Schmelzeextrudieren oder Gießen hergestellt. Geeignet sind Kunststoffe und Verfahren, mit denen durch die Einarbeitung handelsüblicher Leitruße ein spezifischer Durchgangswiderstand von 0,05 bis 1000 $\Omega$cm, bevorzugt 0,1 bis 100 $\Omega$cm, besonders bevorzugt 0,5 bis 10 $\Omega$cm bei ausreichenden mechanischen Eigenschaften und hinreichend geringen Toleranzen des spezifischen Durchgangswiderstandes erreicht werden kann.

Geeignete Materialien sind z.B. Polycarbonat, Polyamid, Polyester. Bevorzugt wird Polycarbonat verwendet.

Die Kupferfolie (5) besteht vorzugsweise aus einem Sinterkupfer, das ausreichend niedrige Scherfestigkeit zur Erzielung kantenscharfer Leiterbahnen aufweist.

Die Trennschicht (3) besteht aus einem Schmelzkleber mit einem Schmelzbereich zwischen 30°C und 150°C, bevorzugt 40°C-60°C.

Die Klebschicht (6) besteht aus einem wärmeaktivierbaren Kleber mit einer Aktivierungstemperatur von mehr als 150°C.

Als Substrat (8) können duroplastische und thermoplastische Werkstoffe, die in ihrem Eigenschaftsprofil den Anforderungen für Basismaterial für bedruckte Schaltungen entsprechen, eingesetzt werden.

Die Aluminiumschicht (3) wird vorzugsweise durch Aufdampfen des Aluminiums auf die Trägerfolie (2) im Hochvakuum hergestellt. Der Oberflächenwiderstand der Aluminiumschicht liegt zwischen 0,01 und 10 Ohm, vorzugsweise zwischen 0,5 und 2 Ohm.

Der Gegenstand der Erfindung soll anhand des folgenden Beispiels noch näher erläutert werden.

## Beispiel

Durch Fotoätzen wird das Bild eines Leiterbahnlayouts auf das Prägewerkzeug übertragen. Die Leiterbahnzüge sind 1 mm erhaben.

Eine rußgefüllte Polycarbonatfolie (Makrofol® VP KL 3-1009 der Bayer AG, Leverkusen), Foliendicke 0,02 mm wird auf einer Bandbedampfungsanlage vollflächig mit Aluminium beschichtet. Der Flächenwiderstand der Al-Sichicht beträgt 0,6 Ohm.

In einer Beschichtungsanlage wird eine Kupferfolie aus Sinterkupfer zunächst mit einem wärmeaktivierbaren Kleber beschichtet. Die beschichtete Kupferfolie wird mit der unbeschichteten Seite auf die aluminiumbeschichtete Seite der Kunststoffolie unter Hinzufügen eines Schmelzklebers aufkaschiert.

Die so erhaltene Folienkombination wird auf ein Substratmaterial aufgelegt und Elektrode und Prägewerkzeug aufgesetzt. Durch einen Stromstoß und mit einer Stromdichte von 150 mA/mm² Leiterbahnfläche und einer Dauer von 0,1 s wird die Kuperfolie auf das Substrat aufgeklebt. Beim Abziehen der Trägerfolie bleibt die Kupferfolie entsprechend dem Prägebild haften und reißt an den Klebekanten sauber ab.

## Ansprüche

1. Verfahren zur Herstellung gedruckter Schaltungen durch Aufbringen von Kupfer auf ein Substrat, dadurch gekennzeichnet, daß das die Leiterbahnen bildende Kupfer durch Heißprägen auf das Substrat übertragen wird und die zum Heißprägen erforderliche Wärme in der Trägerfolie des Kupfers erzeugt wird.

2. Verfahren nach Anspruch 1, dadurch gekennzeichnet, daß als Trägerfolie eine mit Ruß gefüllte Polycarbonatfolie eingesetzt wird.

FIG. 1

FIG. 2

FIG. 3